# EUROPÄISCHE PATENTSCHRIFT

(11) **EP 3 183 584 B1**
(45) Veröffentlichungstag und Bekanntmachung des Hinweises auf die Patenterteilung: **24.03.2021**
(21) Anmeldenummer: 15762484.2
(22) Anmeldetag: 21.08.2015
(51) Int. Cl.: G01R 15/22, G01R 19/165, G01R 19/22, G01R 15/14, G05F 1/575

(54) **VERSORGUNGSSPANNUNGSDETEKTIONSEINRICHTUNG UND VERFAHREN ZUR DETEKTION EINER VERSORGUNGSSPANNUNG**
SUPPLY VOLTAGE DETECTION DEVICE AND A METHOD FOR DETECTING A SUPPLY VOLTAGE
DISPOSITIF DE DÉTECTION D'UNE TENSION D'ALIMENTATION ET PROCÉDÉ DE DÉTECTION D'UNE TENSION D'ALIMENTATION

(30) Priorität: 22.08.2014 DE 102014012664
(43) Veröffentlichungstag der Anmeldung: 28.06.2017
(73) Patentinhaber: Eaton Protection Systems IP GmbH & Co. KG, 12529 Schönefeld (DE)
(72) Erfinder: FRÜCHT, Johannes, 59494 Soest-Ampen (DE)
(74) Vertreter: BRP Renaud & Partner mbB Rechtsanwälte Patentanwälte Steuerberater
(86) Internationale Anmeldenummer: PCT/EP2015/001718
(87) Internationale Veröffentlichungsnummer: WO 2016/026579

(56) Entgegenhaltungen:
- DE-A1- 10 205 313
- DE-A1-102009 022 056

## Beschreibung

Die Erfindung betrifft eine Versorgungsspannungsdetektionseinrichtung für insbesondere wenigstens eine Last zur Überwachung einer gleichgerichteten Netzspannung einer Netzspannungsversorgung. Es erfolgt ein Vergleich eines erfassten Netzspannungswertes mit einem vorgegebenen Referenzwert, wobei im Falle des erfassten Netzspannungswertes kleiner als der Referenzwert beispielsweise auf eine Notfallspannung einer Notfallspannungsversorgung durch eine Steuerelektronik umschaltbar ist.

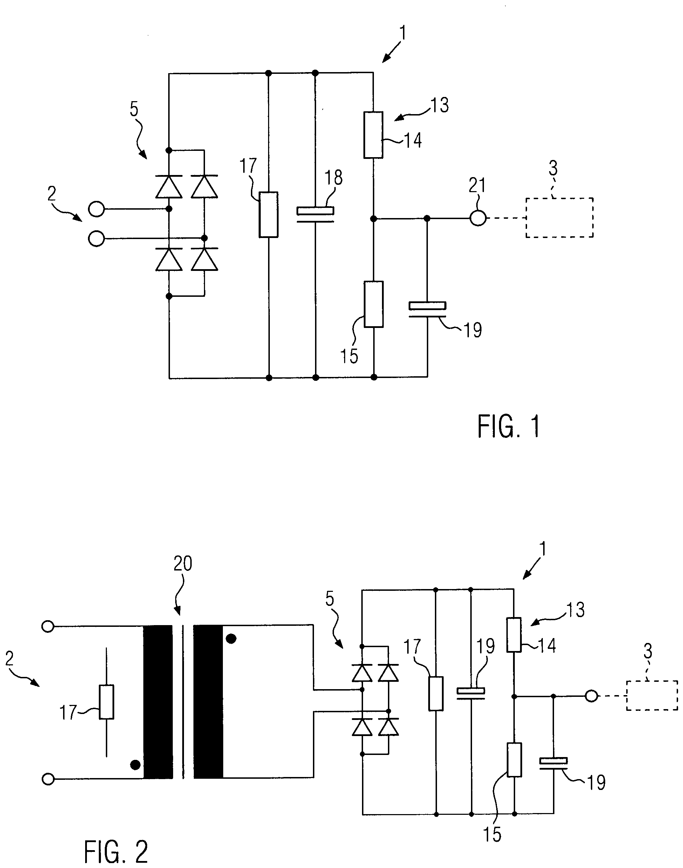

Solche Versorgungsspannungsdetektionseinrichtungen sind aus der Praxis bekannt, siehe Figuren 1 und 2. Eine entsprechende Versorgungsspannungsdetektionseinrichtung wird beispielsweise verwendet, wenn bei einer Beleuchtungsanlage die Netzspannung ausfällt und auf eine Notfallspannung zur Weiterversorgung zumindest einiger Teile der Beleuchtungsanlage umgeschaltet werden soll. Dazu wird der entsprechende Netzspannungswert erfasst und mit dem vorgegebenen Referenzwert verglichen. Ist der Netzspannungswert unterhalb des Referenzwertes, erfolgt das Umschalten auf die Notfallspannungsversorgung. Es besteht ebenfalls die Möglichkeit, dass bei Wiederanlegen der Netzspannungsversorgung und einem entsprechenden Netzspannungswert größer als der vorgegebene Referenzwert ein Zurückschalten von der Notfallspannungsversorgung auf die Netzspannungsversorgung durch die gleiche Steuerelektronik erfolgt.

Relevanter Stand der Technik findet sich beispielsweise in den Dokumenten DE10205313 und DE102009022056.

Der entsprechend vorgegebene Referenzwert ist beispielsweise durch Normen oder dergleichen vorgegeben.

Figur 1 zeigt ein aus der Praxis bekanntes Beispiel einer Versorgungsspannungsdetektionseinrichtung 1. Diese weist einen Gleichrichter 5 zur Gleichrichtung der von einer Netzspannungsversorgung 2 zugeführten Netzspannung auf. Die gleichgerichtete Netzspannung wird über einen Spannungsteiler 13 mit Widerständen 14 und 15 vermindert und Kondensatoren 18 und 19 sind zur Bereitstellung einer entsprechend geglätteten Gleichspannung vorgegeben. Diese Spannung wird über einen Ausgang 21 einer Steuerelektronik 3 zugeführt. Mittels dieser Steuerelektronik wird der anliegende Spannungswert erfasst und entsprechend erfolgt ein Vergleich mit dem vorgegebenen Referenzwert. Eine Last 17 ist im Prinzip zusätzlich in Figur 1 dargestellt.

Nachteil bei der dargestellten Schaltung nach Figur 1 ist, dass beispielsweise keine galvanische Trennung zwischen Netzspannungsversorgung 2 und Steuerelektronik 3 vorhanden ist. Außerdem kann die Last 17 den am Ausgang 21 erfassten Spannungswert beeinflussen. Die Kondensatoren 18 und 19 sind in der Regel Elektrolyt-Kondensatoren zum Glätten der Spannung. Diese sind zusätzlich notwendig und für exakte Messungen des Netzspannungswertes ist eine geringe Welligkeit der Spannung erforderlich, sodass entsprechende Anforderungen an die Kondensatoren 18 und 19 zu stellen sind.

Bei der Schaltung nach Figur 2 ist ein weiteres aus der Praxis bekanntes Beispiel für eine Versorgungsspannungsdetektionseinrichtung 1 dargestellt. Diese ist im Wesentlichen analog zu der Einrichtung nach Figur 1 aufgebaut, außer dass zusätzlich ein Transformator 20 zwischen Netzspannungsversorgung 2 und Gleichrichter 5 verschaltet ist. Dieser Transformator 20 bildet eine galvanische Trennung, wobei ansonsten die Schritte zur Detektion des Netzspannungswertes und dessen Vergleich mit Referenzwert wie bei Figur 1 ablaufen.

Die im Zusammenhang mit Figur 1 geschilderten Nachteile sind bis auf die galvanische Trennung auch in Figur 2 zu beachten. Außerdem weisen oft Transformatoren mit geringer Leistung eine Charakteristik auf, bei der der am Ausgang 21 anliegende Netzspannungswert hohe Fluktuation bei geringen Lastvariationen aufweisen kann.

Zusätzlich ist in Figur 2 eine andere Anordnung der Last 17 dargestellt, siehe die Anordnung zwischen Netzspannungsversorgung 2 und Transformator 20.

Der Erfindung liegt die Aufgabe zugrunde, eine Versorgungsspannungsdetektionseinrichtung der eingangs genannten Art dahingehend zu verbessern, dass mit geringerem Aufwand eine entsprechende Netzspannung mit erhöhter Genauigkeit und in schneller und sicherer Weise bestimmbar ist.

Diese Aufgabe wird erfindungsgemäß durch die Merkmale des Patentanspruchs 1 gelöst. Insbesondere zeichnet sich die erfindungsgemäße Versorgungsspannungsdetektionseinrichtung dadurch aus, dass die gleichgerichtete Netzspannung bei Überschreiten eines Grenzspannungswertes einem Optokoppler zugeführt ist und ein Signal vom Optokoppler für die Dauer dieses Überschreitens übertragbar ist, wobei aus Signaldauer und Periode des Signals ein von dem Netzspannungswert abhängiger Tastgrad ermittelbar ist.

Erfindungsgemäß sind keine Kondensatoren zur Glättung der Spannung notwendig, und die Erfassung des Netzspannungswertes erfolgt digital. Durch den Optokoppler wird eine galvanische Trennung bereitgestellt und gleichzeitig erfolgt die digitale Umsetzung des Netzspannungswertes in ein Signal mit festem Wert. Solange der Netzspannungswert einen bestimmten Grenzspannungswert überschreitet, ist der Optokoppler aktiv und das Signal wird durch den Optokoppler für die Dauer dieses Überschreitens übertragen. Es lässt sich dann aus Signaldauer und -periode des Signals ein von dem Netzspannungswert abhängiger Tastgrad mittels der Steuerelektronik ermitteln.

Dadurch ist die Genauigkeit erhöht und gleichzeitig in einfacher Weise eine galvanische Trennung realisiert. Zwar wird der Optokoppler als zusätzliches Bauteil verwendet, allerdings kann auf entsprechende Kondensatoren verzichtet werden. Wird als Steuerelektronik ein entsprechender Mikro-Controller verwendet, kann die Detektion des Netzspannungswertes und der Vergleich mit entsprechendem Referenzwert mit hoher Genauigkeit und schnell durchgeführt werden. Dadurch kann ein entsprechendes Umschalten von beispielsweise Netzspannungsversorgung auf Notfallspannungsversorgung ebenfalls schnell und genau erfolgen, wobei dies auch in umgekehrter Weise, d. h. ein Zurückschalten von Notfallspannungsversorgung auf Netzspannungsversorgung, erfolgen kann.

Bei der erfindungsgemäßen Versorgungsspannungsdetektionseinrichtung erfolgt ebenfalls eine Gleichrichtung der Netzspannung, wobei die entsprechende Schaltung einen mit der Netzspannungsversorgung verbundenen Gleichrichter aufweist.

In der erfindungsgemäßen Schaltung wird zusätzlich ein Grenzspannungswert verwendet, wobei nur bei Überschreiten dieses Grenzspannungswertes durch den Netzspannungswert der Optokoppler aktiv ist. Dieser Grenzspannungswert ergibt sich durch eine Zenerdiodeneinrichtung aus zumindest einer Zenerdiode, die zwischen Gleichrichter und Optokoppler verschaltet ist. D. h., der Grenzspannungswert ist durch die entsprechende Zenerspannung bestimmt.

Gleichzeitig ist die Zenerdiodeneinrichtung beispielsweise durch Verwenden einer anderen Zenerdiode oder durch Verwenden mehrerer Zenerdioden leicht an unterschiedliche Betriebsbedingungen anpassbar, sodass auf diese Weise unterschiedliche Zenerspannungen und damit Grenzspannungswerte zum Vergleich mit dem Netzspannungswert realisiert werden können.

Um eine Belastung durch zu hohe Ströme zu unterbinden, kann ein Strombegrenzungswiderstand in Reihe mit der Zenerdiodeneinrichtung verschaltet werden. Ein solcher Strombegrenzungswiderstand kann aus mehreren Widerständen oder auch aus nur einem Widerstand gebildet sein.

Bei einem einfachen Ausführungsbeispiel eines Optokopplers weist dieser eine LED (Licht emittierende Diode) als optischen Sender und einen Fototransistor als optischen Empfänger auf.

Der Fototransistor empfängt entsprechendes Licht von der LED und ist nur während des Empfangs eines solchen Lichts leitend, d. h. während der entsprechenden Signaldauer, während der der Netzspannungswert den Grenzspannungswert überschreitet.

Um ein gut reproduzierbares und in seinen Pegel gut unterscheidbares Signal an einem entsprechenden Tast-Ausgang der Steuerelektronik zuführen zu können, kann der Fototransistor ein elektronisches Schaltelement ansteuern, welches im Wesentlichen während der Signaldauer leitend ist, und an den Tast-Ausgang einen H-Pegel während der Signaldauer und ansonsten einen L-Pegel anlegt. Die entsprechenden Pegel werden von der Steuerelektronik erfasst und zur Ermittlung des Tastgrades verwendet.

Insbesondere sei noch einmal darauf hingewiesen, dass der L-Pegel sich bei einem Netzspannungswert kleiner als dem Grenzspannungswert ergibt und in diesem Fall durch den Optokoppler keine Signalübertragung erfolgt.

Zur Reduzierung der entsprechenden Spannung am elektronischen Schaltbauteil kann diesem ein Spannungsteiler zugeordnet sein.

Es wurde bereits darauf hingewiesen, dass die Steuerelektronik mit dem Tast-Ausgang verbunden ist und so aus Signaldauer und Periode der Signale den Tastgrad ermittelt. Um die entsprechenden Pegel genau ermitteln zu können, kann die Steuerelektronik eine Filtereinrichtung aufweisen.

Es wurde darauf hingewiesen, dass der vorgegebene Referenzwert dazu dient, bei Vorliegen eines Netzspannungswertes geringer als dieser Referenzwert ein Umschalten auf beispielsweise Notfallspannungsversorgung vorzunehmen. Erfindungsgemäß ist nicht nur ein solches Umschalten mittels der Steuerelektronik möglich, sondern auch bei einem Netzspannungswert größer als dem Referenzwert ist der entsprechende Netzspannungswert über den Tastgrad zu ermitteln. Dies ist insbesondere dann möglich, wenn der Grenzspannungswert kleiner als der Referenzwert ist.

Bei einem vorteilhaften Ausführungsbeispiel ist zwischen Zenerdiodeneinrichtung und optischem Sender eine Reihenschaltung aus Diode und Widerstand angeordnet. Insbesondere von Vorteil ist in diesem Zusammenhang, wenn über diese Reihenschaltung und mit dem entsprechenden Widerstand als Teil eines Spannungsteilers ein Kondensator aufladbar ist. Dieser ist beispielsweise durch eine Parallelschaltung von entsprechendem Kondensator und Diode realisiert.

Über die Reihenschaltung aus Diode und Widerstand wird dieser Kondensator geladen und die Diode dient insbesondere dazu, dass bei Null-Durchgängen der Versorgungsspannung der Kondensator nicht jedes Mal wieder entladen wird. Über die parallel geschaltete Diode zum Kondensator wird dabei gewährleistet, dass die Spannung am Kondensator einen konstanten Wert aufweist. Dies führt insbesondere dazu, dass der optische Empfänger immer im Wesentlichen mit gleicher Energie betrieben wird.

In der bisher beschriebenen Ausführungsform der Erfindung war der durch die Zenerdiodeneinrichtung und den Optokoppler fließende Strom gleich groß. Dies kann bei thermischen Änderungen dazu führen, dass die entsprechenden Fluß-Spannungen der Optokopplerdiode beziehungswese des optischen Sensors und der Zenerdiodeneinrichtung zu starken Änderungen des Tastverhältnisses führen. Bei dem weiteren Ausführungsbeispiel der Erfindung fließt über die Zenerdiodeneinrichtung nur ein entsprechender Basisstrom des optischen Sensors, wodurch sich kaum Änderungen der Fluß-Spannung ergeben. Der optische Empfänger wird daher auch nahezu mit konstantem Strom betrieben. Dadurch ergibt sich bei dem weiteren Ausführungsbeispiel ein wesentlich stabilerer Betrieb über einen großen Temperaturbereich.

Im Folgenden wird ein vorteilhaftes Ausführungsbeispiel der Erfindung anhand der in der Zeichnung beigefügten Figuren näher erläutert.

Es zeigen:
- Figur 1: eine Prinzipdarstellung einer aus der Praxis bekannten Versorgungsspannungsdetektionseinrichtung;
- Figur 2: ein weiteres Beispiel einer aus der Praxis bekannten Versorgungsspannungsdetektionseinrichtung,
- Figur 3: eine Prinzipdarstellung einer erfindungsgemäßen Versorgungsspannungsdetektionseinrichtung mit galvanischer Trennung nach erstem Ausführungsbeispiel, und
- Figur 4: ein zweites Ausführungsbeispiel der erfindungsgemäßen Versorgungsspannungsdetektionseinrichtung.

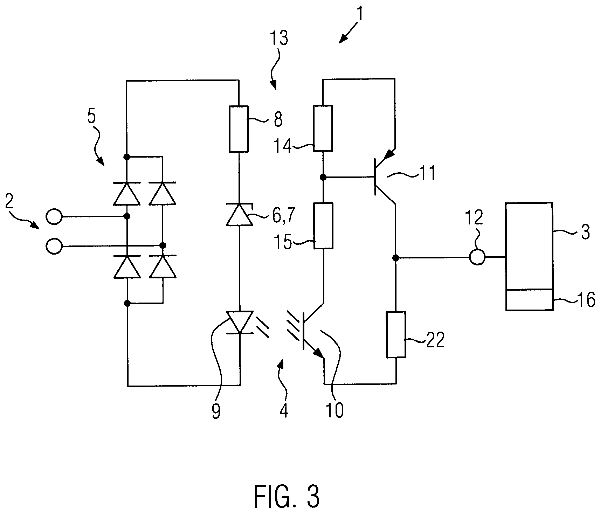

Die erfindungsgemäße Versorgungsspannungsdetektionseinrichtung 1 (Figur 3) ist über einen Gleichrichter 5 mit der Netzspannungsversorgung 2 verbunden. Nach Gleichrichten der Netzspannung wird diese über einen Strombegrenzungswiderstand 8 und eine Zenerdiodeneinrichtung 6, 7 einem Optokoppler 4 zugeführt. Es erfolgt keine Glättung der Spannung durch beispielsweise Kondensatoren, wie Elektrolyt-Kondensatoren oder dergleichen.

Die gleichgerichtete Netzspannung dient zum Betätigung des Optokopplers. Zwischen Gleichrichter 5 und Optokoppler 4 ist eine Zenerdiodeneinrichtung 6 verschaltet. Diese weist zumindest eine Zenerdiode 7 auf. Nur bei einem Netzspannungswert größer als eine entsprechende Zenerspannung als Grenzspannung erfolgt ein Einschalten des Optokopplers mit entsprechend einer LED 9 als optischem Sender und einem Fototransistor 10 als optischem Empfänger. Gleichzeitig wird durch den Strombegrenzungswiderstand 8 aus einem oder mehreren Widerständen eine Strombegrenzung ermöglicht, wobei dieser Strombegrenzungswiderstand 8 in Reihe zwischen Zenerdiode 7 und Gleichrichter 5 verschaltet ist.

Der Fototransistor 10 des Optokopplers ist leitend, wenn der Netzspannungswert höher als die durch die Zenerspannung bestimmte Grenzwertspannung ist. Leitet der Fototransistor 10, steuert er ein elektronisches Schaltelement 11 an, sodass dieses ebenfalls leitfähig ist. Entsprechend liegt ein H-Pegelsignal am Tast-Ausgang 12 an. Ist der Netzspannungswert geringer als der Grenzspannungswert, ist der Optokoppler inaktiv und der Fototransistor 10 nicht leitend. Folglich liegt ein L-Pegelsignal am Tast-Ausgang 12 an.

Es sei noch angemerkt, dass die Netzspannung in der Regel eine Frequenz von 50 Hz aufweist, sodass ein entsprechendes Signal von 100 Hz am Tastausgang 12 aufgrund der entsprechenden Gleichrichtung der Netzspannung anliegt. Der entsprechende Tastgrad beziehungsweise das Tastverhältnis ergibt sich als Ein-Aus-Verhältnis oder insbesondere als Verhältnis von Signaldauer zu Signalperiode. Dabei ist weiterhin zu beachten, dass der Tastgrad beziehungsweise das Tastverhältnis von der Höhe des Netzspannungswertes abhängt. Ist die Netzspannung gering, ist ebenfalls die Dauer des H-Pegelsignals gering und ist die Netzspannung hoch, ist ebenfalls die Dauer des H-Pegelsignals hoch. D. h., durch den Tastgrad beziehungsweise das Tastverhältnis ergibt sich die Möglichkeit, zum Netzspannungswert eine Aussage zu machen, da es die entsprechende Abhängigkeit des Tastgrades vom Netzspannungswert wiedergibt.

Die Ermittlung der Dauer von H-Pegelsignal, L-Pegelsignal, Tastgrad und dergleichen erfolgt durch die Steuerelektronik 3, die beispielsweise als Mikro-Controller ausgebildet sein kann. Dieser kann eine Filtereinrichtung aufweisen, die eine genaue Bestimmung der entsprechenden Pegel ermöglicht. Eine solche Filtereinrichtung 16 kann auch softwaremäßig innerhalb des Mikro-Controllers realisiert sein.

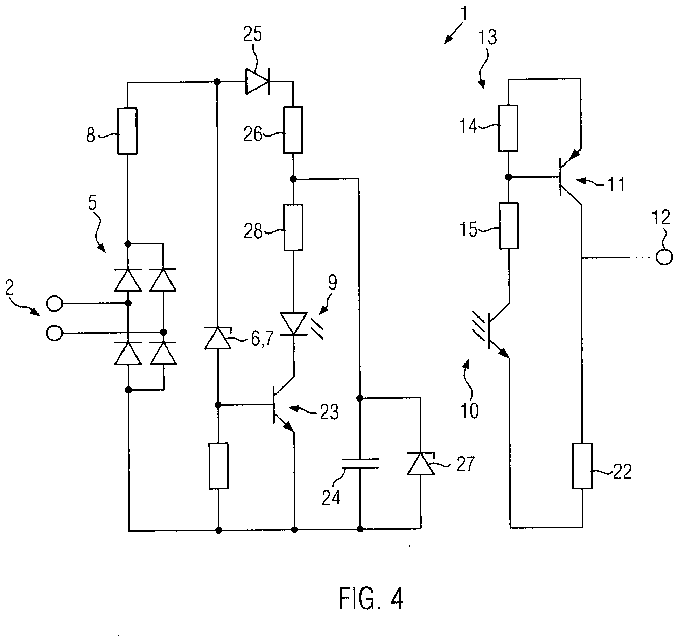

Figur 4 zeigt ein weiteres Ausführungsbeispiel einer erfindungsgemäßen Versorgungsspannungsdetektionseinrichtung 1. Gleiche Teile sind mit gleichen Bezugszeichen im Vergleich zum ersten Ausführungsbeispiel nach Figur 3 gekennzeichnet.

Bei dem Ausführungsbeispiel nach Figur 4 ist insbesondere zwischen der Zenerdiodeneinrichtung 6 und dem Optokoppler beziehungsweise dem optischen Sender 9 eine Reihenschaltung von Diode 25 und Widerstand 26 angeordnet. Über diese fließt der Strom nicht nur in Richtung optischer Sender 9, sondern auch in Richtung einer Parallelanordnung von Kondensator 24 und Zenerdiode 27. Der Widerstand 26 ist Teil eines Spannungsteilers, der den weiteren Widerstand 28 zwischen Widerstand 26 und optischem Sender 9 umfasst. Von diesem Spannungsteiler erfolgt die Versorgung der Parallelanordnung von Kondensator 24 und Zenerdiode 27. Auf Seiten des optischen Empfängers liegt der gleiche Aufbau wie bei dem Ausführungsbeispiel nach Figur 3.

Bei dem in Figur 4 dargestellten Ausführungsbeispiel ist insbesondere zu beachten, dass bei einer bestimmten Spannung der optische Sender 9 immer leitend ist. Diese bestimmte Spannung wird durch die Zenerdiodeneinrichtung 6 mit entsprechender Zenerdiode 7 bestimmt. Solange die Spannung nach dem Gleichrichter 5 größer als der entsprechende Wert dieser Zenerdiodeneinrichtung 6 ist, ist der optische Sender 9 leitend. Hinter dem Gleichrichter 5 liegt eine gleichgerichtete Spannung ohne Siebung vor, d.h., bei 50 Hz Netzspannungsversorgung liegt ein 100 Hz- Signal vor.

Allerdings weist die Netzspannungsversorgung Null-Durchgänge auf, bei denen Pausen der Versorgung beim optischen Sender 9 auftreten. D.h., in diesen Pausen wird der Optokoppler nicht angesteuert. Bei einer hohen Eingangsspannung ist eine solche Pause relativ kurz und je kleiner die Eingangsspannung beziehungsweise Netzspannungsversorgung ist, desto länger wird die Pause.

Der optische Sender 9 bestimmt das Tastverhältnis in Abhängigkeit von der Netzspannungsversorgung. Über die Diode 25 und den Widerstand 26 wird der Kondensator 24 geladen. Die Diode 25 verhindert in diesem Zusammenhang, dass bei den oben genannten Null-Durchgängen der Kondensator 24 jedes Mal wieder entladen wird. Durch die Parallelschaltung der Zenerdiode 27 zum Kondensator 24 wird die Spannung am Kondensator 24 auf einen konstanten Wert festgelegt, sodass der Optokoppler immer mit gleicher Energie betrieben wird.

Ein weiterer Vorteil bei dem zweiten Ausführungsbeispiel ist in diesem Zusammenhang, dass beim ersten Ausführungsbeispiel über die Zenerdiodeneinrichtung gleicher Strom wie durch den Optokoppler fließt. Bei thermischen Änderungen kann dies dazu führen, dass Fluß-Spannung des optischen Senders und der Zenerdiodeneinrichtung zu Änderungen des Tastverhältnisses führen. Bei dem zweiten Ausführungsbeispiel fließt über die Zenerdiodeneinrichtung 6 nur der entsprechende Basisstrom des optischen Senders, was kaum zu Änderungen der Fluß-Spannung führen kann. D.h., der optische Empfänger 10 wird jetzt mit nahezu konstantem Strom stetig betrieben. Dies führt zu einem stabileren Betrieb der Versorgungsspannungsdetektionseinrichtung über einen großen Temperaturbereich.

Erfindungsgemäß ergibt sich somit eine Schaltung mit galvanischer Trennung, die in einfacher und genauer Weise eine Bestimmung eines Netzspannungswertes und eine Entscheidung zum Umschalten zwischen Netzspannungsversorgung und Notfallspannungsversorgung beispielsweise ermöglicht. Die entsprechenden Wellenformen des Signals werden durch unterschiedliche Lastsituationen, siehe die Ausführungen zu Figuren 1 und 2, nicht beeinflusst und insbesondere sind keine Elektrolyt-Kondensatoren notwendig.

Da eine Ermittlung des Netzspannungswertes in sehr genauer Weise erfolgt, ist selbstverständlich auch ein entsprechender genauer Vergleich mit dem vorgegebenen Referenzwert möglich, um gegebenenfalls eine Entscheidung zum Umschalten zwischen Netzspannungsversorgung und Notfallspannungsversorgung zu treffen. Dadurch werden entsprechende Anforderungen von Normen oder dergleichen in sicherer Weise erfüllt.

Weiterhin ist zu beachten, dass die Zenerdiodeneinrichtung zur entsprechenden Vorgabe des Grenzspannungswertes auswählbar ist. Es wurde bereits darauf hingewiesen, dass sich der Grenzspannungswert aus der Zenerspannung ergibt und dieser die Einschalt- und Ausschaltdauer des Optokopplers bei Vergleich mit dem Netzspannungswert bestimmt.

Die erfindungsgemäße Versorgungsspannungsdetektionseinrichtung kann in einer Notlichtbeleuchtung oder dergleichen eingesetzt werden, d. h. in allen Einrichtungen, die beispielsweise bei Ausfall einer Netzspannung von einer Notfallspannungsversorgung weiter betrieben werden müssen. Nicht nur der entsprechende Wert der Netzspannung kann erfindungsgemäß ermittelt werden, sondern auch ein entsprechender Zeitpunkt zum Umschalten auf Notfallspannungsversorgung oder zurück auf Netzspannungsversorgung ist sicher und genau erfassbar. Die entsprechende Versorgungsspannungsdetektionseinrichtung kann je nach Einsatzgebiet an unterschiedlichen Stellen angeordnet werden. Es ist denkbar, die Einrichtung der Netzspannungsversorgung zuzuordnen oder auch einer Zentralbatterie oder dergleichen, die die entsprechende Notfallspannung bereitstellt. Außerdem ist die Versorgungsspannungsdetektionseinrichtung auch mehrfach, beispielsweise im Zusammenhang mit insbesondere explosionsgeschützten Leuchten bei einer Gebäudebeleuchtungsanlage einsetzbar. Dies gilt allgemein auch für eine explosionsgeschützte, elektrische Installationstechnik, die von der Beleuchtung über die Überwachung, Steuerung, Signalisierung, Mess- und Regeltechnik bis hin zur Verteilung von elektrischen Energien in explosionsgefährdeten Bereichen Verwendung findet. Selbstverständlich besteht ebenfalls die Möglichkeit, statt auf eine Notfallspannungsversorgung umzuschalten, andere Maßnahmen bei bestimmten Netzspannungswerten zu ergreifen, die beispielsweise den Explosionsschutz oder dergleichen betreffen. Außerdem besteht die Möglichkeit, zumindest oberhalb des Grenzspannungswertes bei unterschiedlichen Werten der Netzversorgungsspannung unterschiedliche Reaktionen zu veranlassen, da erfindungsgemäß der Netzspannungswert schnell und genau erfassbar ist. D. h., es kann ebenfalls auch ein Vergleich des Netzspannungswertes mit mehreren vorgegebenen Referenzwerten stattfinden, um je nach Größe des Netzspannungswertes dann unterschiedliche Reaktionen bei entsprechendem Referenzwert auszulösen.

## Patentansprüche

1. Versorgungsspannungsdetektionseinrichtung (1) für wenigstens eine Last zur Überwachung einer gleichgerichteten Netzspannung einer Netzspannungsversorgung (2) und zum Vergleich eines erfassten Netzspannungswertes mit einem vorgegebenen Referenzwert, wobei im Falle des erfassten Netzspannungswertes kleiner als der Referenzwert durch eine Steuerelektronik (3) auf beispielsweise eine Notfallspannung einer Notfallspannungsversorgung umschaltbar ist, **dadurch gekennzeichnet, dass** die gleichgerichtete Netzspannung bei Überschreiten eines Grenzspannungswertes einem Optokoppler (4) zuführbar ist und ein Signal vom Optokoppler für die Dauer dieses Überschreitens übertragbar ist, wobei aus Signaldauer und Periode dieses Signals ein von dem Netzspannungswert abhängiger Tastgrad ermittelbar ist, wobei eine Zenerdiodeneinrichtung (6) aus zumindest einer Zenerdiode (7) zwischen Gleichrichter (5) und Optokoppler (4) verschaltet ist, wobei der Grenzspannungswert durch die Zenerspannung bestimmt ist.

2. Versorgungsspannungsdetektionseinrichtung nach Anspruch 1, **dadurch gekennzeichnet, dass** diese einen mit der Netzspannungsversorgung (2) verbundenen Gleichrichter (5) aufweist.

3. Versorgungsspannungsdetektionseinrichtung nach Anspruch 1 oder 2, **dadurch gekennzeichnet, dass** ein Strombegrenzungswiderstand (8) in Reihe mit der Zenerdiodeneinrichtung (6) verschaltet ist.

4. Versorgungsspannungsdetektionseinrichtung nach einem der vorangehenden Ansprüche, **dadurch gekennzeichnet, dass** der Optokoppler (4) aus zumindest einer LED (9) als optischem Sender und einem Fototransistor (10) als optischem Empfänger gebildet ist.

5. Versorgungsspannungsdetektionseinrichtung nach einem der vorangehenden Ansprüche, **dadurch gekennzeichnet, dass** der Fototransistor (10) im Wesentlichen während der Signaldauer leitend ist.

6. Versorgungsspannungsdetektionseinrichtung nach einem der vorangehenden Ansprüche, **dadurch gekennzeichnet, dass** der Fototransistor (10) ein elektronisches Schaltelement (11) ansteuert, welches im Wesentlichen während der Signaldauer leitend ist und an einem Tast-Ausgang (12) einen H-Pegel und ansonsten einen L-Pegel anlegt.

7. Versorgungsspannungsdetektionseinrichtung nach einem der vorangehenden Ansprüche, **dadurch gekennzeichnet, dass** der L-Pegel sich bei einem Netzspannungswert kleiner als dem Grenzspannungswert ergibt und in diesem Fall kein Signal vom Optokoppler (4) übertragbar ist.

8. Versorgungsspannungsdetektionseinrichtung nach einem der vorangehenden Ansprüche, **dadurch gekennzeichnet, dass** dem elektronischen Schaltelement (11) ein Spannungsteiler (13, 14, 15) zugeordnet ist.

9. Versorgungsspannungsdetektionseinrichtung nach einem der vorangehenden Ansprüche, **dadurch gekennzeichnet, dass** die Steuerelektronik (3) mit dem Tast-Ausgang (12) verbunden ist.

10. Versorgungsspannungsdetektionseinrichtung nach einem der vorangehenden Ansprüche, **dadurch gekennzeichnet, dass** die Steuerelektronik (3) eine Filtereinrichtung (16) aufweist.

11. Versorgungsspannungsdetektionseinrichtung nach einem der vorangehenden Ansprüche, **dadurch gekennzeichnet, dass** der Grenzspannungswert kleiner oder gleich dem Referenzwert ist.

12. Versorgungsspannungsdetektionseinrichtung nach einem der vorangehenden Ansprüche, **dadurch gekennzeichnet, dass** zwischen Zenerdiodeneinrichtung (6) und optischem Sender (9) eine Reihenschaltung aus zumindest Diode (25) und Widerstand (26) angeordnet ist.

13. Versorgungsspannungsdetektionseinrichtung nach einem der vorangehenden Ansprüche, **dadurch gekennzeichnet, dass** dem optischen Sender (9) ein Spannungsteiler (26, 28) zugeordnet ist, der mit einer Parallelschaltung aus Kondensator (24) und Diode (27), insbesondere Zenerdiode (27) verschaltet ist.

14. Versorgungsspannungsdetektionseinrichtung nach einem der vorangehenden Ansprüche, **dadurch gekennzeichnet, dass** der Widerstand (26) der Reihenschaltung aus Diode (25) und Widerstand Teil des Spannungsteilers (26, 28) ist.

15. Verfahren zur Detektion einer Netzspannung einer Netzspannungsversorgung (2) für wenigstens eine Leuchte, wobei ein Netzspannungswert der gleichgerichteten Netzspannung erfasst und mit einem vorgegebenen Referenzwert verglichen wird und im Falle des erfassten Netzspannungswertes kleiner als dem Referenzwert durch eine Steuerelektronik auf eine Notfallspannung einer Notfallspannungsversorgung umgeschalten wird, **dadurch gekennzeichnet, dass** weiterhin die gleichgerichtete Netzspannung bei Überschreiten eines Grenzspannungswertes einem Optokoppler zugeführt und ein Signal vom Optokoppler für die Dauer dieses Überschreitens übertragen wird, sowie aus der Signaldauer und der Periode des Signals ein von dem Netzspannungswert abhängiger Tastgrad ermittelt wird, wobei mittels einer Zenerdiodeneinrichtung (6) aus zumindest einer Zenerdiode (7) zwischen einem Gleichrichter (5) und Optokoppler (4) der Grenzspannungswert durch die Zenerspannung bestimmt wird.

## Claims

1. Supply voltage detection device (1) for at least one load for monitoring a rectified grid voltage of a grid voltage supply (2) and for comparing a detected grid voltage value to a predetermined reference value, wherein, in the case of a detected grid voltage value that is less than the reference value, a control electronics unit (3) can switch, for example, to an emergency voltage of an emergency voltage supply, **characterized in that** the rectified grid voltage can be fed to an optocoupler (4) when a limit voltage value is exceeded, and a signal from the optocoupler can be transmitted for the duration of this exceedance, wherein a duty cycle dependent upon the grid voltage value can be ascertained from the signal duration and period of this signal, wherein a Zener diode device (6) comprising at least one Zener diode (7) is connected between a rectifier (5) and the optocoupler (4), wherein the limit voltage value is determined by the Zener voltage.

2. Supply voltage detection device according to claim 1, **characterized in that** it has a rectifier (5) connected to the grid voltage supply (2).

3. Supply voltage detection device according to claim 1 or 2, **characterized in that** a current-limiting resistor (8) is connected in series to the Zener diode device (6).

4. Supply voltage detection device according to one of the preceding claims, **characterized in that** the optocoupler (4) is formed from at least one LED (9) as an optical transmitter and a phototransistor (10) as an optical receiver.

5. Supply voltage detection device according to one of the preceding claims, **characterized in that** the phototransistor (10) is conductive primarily during the signal duration.

6. Supply voltage detection device according to one of the preceding claims, **characterized in that** the phototransistor (10) controls an electronic switching element (11), which is conductive primarily during the signal duration and applies an H-level and otherwise an L-level at a sensing output (12).

7. Supply voltage detection device according to one of the preceding claims, **characterized in that** the L-level results at a grid voltage value that is less than the limit voltage value, and, in this case, no signal can be transmitted by the optocoupler (4).

8. Supply voltage detection device according to one of the preceding claims, **characterized in that** a voltage divider (13, 14, 15) is assigned to the electronic switching element (11).

9. Supply voltage detection device according to one of the preceding claims, **characterized in that** the control electronics unit (3) is connected to the sensing output (12).

10. Supply voltage detection device according to one of the preceding claims, **characterized in that** the control electronics unit (3) has a filter device (16).

11. Supply voltage detection device according to one of the preceding claims, **characterized in that** the limit voltage value is less than or equal to the reference value.

12. Supply voltage detection device according to one of the preceding claims, **characterized in that** a series circuit comprising at least a diode (25) and a resistor (26) is arranged between the Zener diode device (6) and the optical transmitter (9).

13. Supply voltage detection device according to one of the preceding claims, **characterized in that** the optical transmitter (9) is assigned a voltage divider (26, 28) which is connected to a parallel circuit comprising a capacitor (24) and a diode (27) - in particular, a Zener diode (27).

14. Supply voltage detection device according to one of the preceding claims, **characterized in that** the resistor (26) of the series circuit comprising the diode (25) and the resistor is part of the voltage divider (26, 28).

15. Method for detecting a grid voltage of a grid voltage supply (2) for at least one luminaire, wherein a grid voltage value of the rectified grid voltage is detected and compared to a predetermined reference value and, in the case of a detected grid voltage value that is less than the reference value, is switched by control electronics to an emergency voltage of an emergency voltage supply, **characterized in that**, furthermore, the rectified grid voltage is fed to an optocoupler when the limit voltage value is exceeded, and a signal is transmitted from the optocoupler for the duration of this exceedance, and a duty cycle dependent upon the grid voltage value is ascertained from the signal duration and the period of the signal, wherein the limit voltage value is determined by the Zener voltage by means of a Zener diode device (6) comprising at least one Zener diode (7) between a rectifier (5) and the optocoupler (4).

## Revendications

1. Dispositif (1) de détection de tension d'alimentation pour au moins une charge, destiné à surveiller une tension de réseau redressée d'une alimentation en tension de réseau (2) et à comparer une valeur de tension de réseau détectée à une valeur de référence prédéfinie, dans le cas où la valeur de tension de réseau détectée est inférieure à la valeur de référence, une électronique de commande (3) pouvant assurer une commutation par exemple sur une tension d'urgence d'une alimentation en tension d'urgence, **caractérisé en ce que** la tension de réseau redressée peut être introduite dans un optocoupleur (4) lorsque ladite tension de réseau redressée passe au-dessus d'une valeur de tension limite et un signal de l'optocoupleur peut être transmis pour la durée de ce dépassement, un rapport cyclique dépendant de la valeur de tension de réseau pouvant être déterminé à partir de la durée du signal et de la période de ce signal, un dispositif à diode Zener (6) constitué par au moins une diode Zener (7) étant connecté entre un redresseur (5) et l'optocoupleur (4), la valeur de tension limite étant déterminée par la tension Zener.

2. Dispositif de détection de tension d'alimentation selon la revendication 1, **caractérisé en ce que** celui-ci présente un redresseur (5) relié à l'alimentation en tension de réseau (2).

3. Dispositif de détection de tension d'alimentation selon la revendication 1 ou 2, **caractérisé en ce qu'**une résistance de limitation de courant (8) est connectée en série avec le dispositif à diode Zener (6).

4. Dispositif de détection de tension d'alimentation selon l'une quelconque des revendications précédentes, **caractérisé en ce que** l'optocoupleur (4) est formé à partir d'au moins une DEL (9) en tant qu'émetteur optique et d'un phototransistor (10) en tant que récepteur optique.

5. Dispositif de détection de tension d'alimentation selon l'une quelconque des revendications précédentes, **caractérisé en ce que** le phototransistor (10) est essentiellement conducteur pendant la durée du signal.

6. Dispositif de détection de tension d'alimentation selon l'une quelconque des revendications précédentes, **caractérisé en ce que** le phototransistor (10) commande un élément de commutation électronique (11), qui est essentiellement conducteur pendant la durée du signal et qui applique à une sortie en impulsions (12) un niveau H et sinon un niveau L.

7. Dispositif de détection de tension d'alimentation selon l'une quelconque des revendications précédentes, **caractérisé en ce que** le niveau L est obtenu à une valeur de tension de réseau inférieure à la valeur de tension limite et, dans ce cas, aucun signal ne peut être transmis par l'optocoupleur (4).

8. Dispositif de détection de tension d'alimentation selon l'une quelconque des revendications précédentes, **caractérisé en ce qu'**un diviseur de tension (13, 14, 15) est associé à l'élément de commutation électronique (11).

9. Dispositif de détection de tension d'alimentation selon l'une quelconque des revendications précédentes, **caractérisé en ce que** l'électronique de commande (3) est reliée à la sortie en impulsions (12).

10. Dispositif de détection de tension d'alimentation selon l'une quelconque des revendications précédentes, **caractérisé en ce que** l'électronique de commande (3) présente un dispositif de filtrage (16).

11. Dispositif de détection de tension d'alimentation selon l'une quelconque des revendications précédentes, **caractérisé en ce que** la valeur de tension limite est inférieure ou identique à la valeur de référence.

12. Dispositif de détection de tension d'alimentation selon l'une quelconque des revendications précédentes, **caractérisé en ce qu'**une connexion en série constituée par au moins une diode (25) et par une résistance (26) est disposée entre le dispositif à diode Zener (6) et l'émetteur optique (9).

13. Dispositif de détection de tension d'alimentation selon l'une quelconque des revendications précédentes, **caractérisé en ce qu'**un diviseur de tension (26, 28) est associé à l'émetteur optique (9), lequel diviseur de tension est connecté à une connexion parallèle constituée par un condensateur (24) et une diode (27), en particulier une diode Zener (27).

14. Dispositif de détection de tension d'alimentation selon l'une quelconque des revendications précédentes, **caractérisé en ce que** la résistance (26) de la connexion en série constituée par la diode (25) et par la résistance fait partie du diviseur de tension (26, 28).

15. Procédé pour la détection d'une tension de réseau d'une alimentation en tension de réseau (2) pour au moins un luminaire, une valeur de tension de réseau de la tension de réseau redressée étant détectée et comparée à une valeur de référence prédéfinie et, dans le cas où la valeur de tension de réseau détectée est inférieure à la valeur de référence, une électronique de commande assure une commutation sur une tension d'urgence d'une alimentation en tension d'urgence, **caractérisé en ce que,** en outre, la tension de réseau redressée est introduite dans un optocoupleur lorsque ladite tension dépasse une valeur de tension limite et un signal de l'optocoupleur est transmis pour la durée de ce dépassement et un rapport cyclique dépendant de la valeur de tension de réseau est déterminé à partir de la durée du signal et de la période de ce signal, un dispositif à diode Zener (6) constitué par au moins une diode Zener (7) entre un redresseur (5) et l'optocoupleur (4) déterminant la valeur de tension limite par la tension Zener.
